# EUROPÄISCHE PATENTANMELDUNG

(11) **EP 2 194 160 A1**
(43) Veröffentlichungstag der Anmeldung: **09.06.2010**
(21) Anmeldenummer: 08020903.4
(22) Anmeldetag: 02.12.2008
(51) Int. Cl.: C23C 14/50, C23C 16/458, B25B 11/00, H01F 1/44

(54) **Flexibles Aufnahmesystem für Bauteile und Verfahren damit**

(71) Anmelder: Siemens Aktiengesellschaft, 80333 München (DE)
(72) Erfinder: Beck, Thomas, 16341 Panketal (DE); Lischka, Jan-Marc, 13158 Berlin (DE)

(57) **Zusammenfassung**

Bei der Bearbeitung von Bauteilen kommt es zu langen Spannzeiten, weil die Werkzeuge beim Wechseln aufwändig eingerichtet werden müssen.

Ein flexibles Aufnahmesystem (10), das aus einem mit einer Flüssigkeit gefüllten Beutel besteht, wird anhand eines Referenzbauteils verwendet und kann so für weitere Bauteile beliebig oft verwendet werden.

## Beschreibung

Die Erfindung betrifft ein flexibles Aufnahmesystem für Bauteile und ein Verfahren damit.

Turbinenschaufeln werden bei der mechanischen Bearbeitung der Schaufelfüße oder Deckplatten in aufwändigen Spannsystemen gehaltert. Oft muss dazu in mehreren Aufspannungen gearbeitet werden, weil bei einer Bearbeitungstechnologie (Schleifen, Fräßen oder Erodieren) alle zu bearbeitenden Flächen mit einer Aufspannung nicht erreichbar sind, oder weil beim Technologiewechsel eine andere Aufspannung benötigt wird.

Dies führt dazu, dass für eine Komponente eine Vielzahl von Vorrichtungen zur Aufnahme für die gesamte mechanische Bearbeitung notwendig ist. Neben den langen Spannzeiten müssen diese Werkzeuge beim Wechseln aufwändig eingerichtet werden. Viele Werkzeuge verursachen auch einen großen Aufwand an Werkzeugwartungsarbeiten.

Weiterhin gibt es viele Turbinenschaufeln, die in der Wertschöpfungskette mit Fehleranzeigen auffällig werden. Diese müssen dann nach erfolgter Reparatur wieder mechanisch nachgearbeitet werden. Hierzu bedient man sich sehr oft Hilfsspannsystemen, die sehr aufwändig der jeweiligen Bearbeitung angepasst werden müssen.

Es ist daher Aufgabe der Erfindung, das Problem der Vielzahl von Spannsystemen zu reduzieren.

Die Aufgabe wird gelöst durch ein flexibles Aufnahmesystem gemäß Anspruch 1 und im Verfahren gemäß Anspruch 5.

In den Unteransprüchen sind weitere vorteilhafte Maßnahmen aufgelistet, die beliebig miteinander kombiniert werden können, um weitere Vorteile zu erzielen.

Es zeigen:
- Figur 1: eine Vorrichtung 1' nach dem Stand der Technik,
- Figur 2: ein Beutel mit Fluid,
- Figur 3, 4: eine Vorrichtung mit einem flexiblen Aufnahmesystem,
- Figur 5: eine Gasturbine und

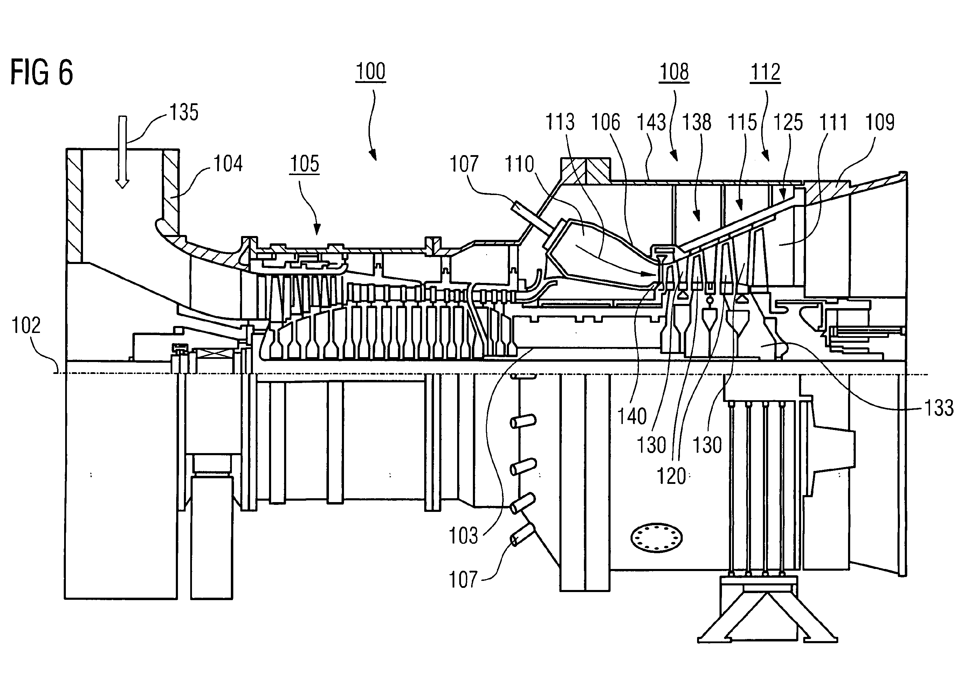

- Figur 6: eine Turbinenschaufel.

Die Beschreibung und die Figuren zeigen nur Ausführungsbeispiele der Erfindung.

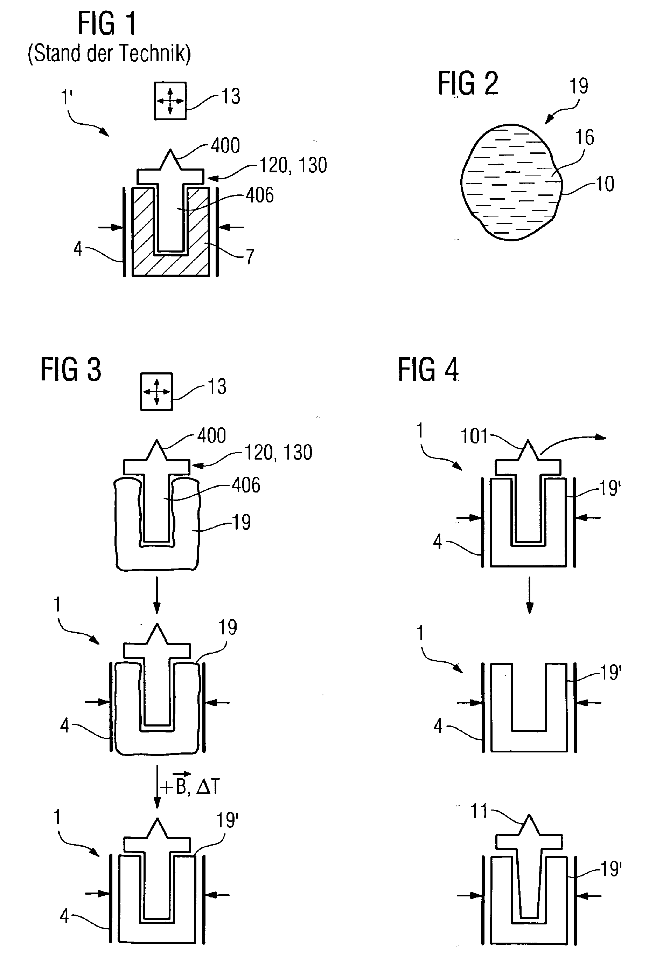

Figur 1 zeigt eine Vorrichtung 1' nach dem Stand der Technik.

Ein Bauteil, hier eine Turbinenschaufel 120, 130 wird in eine massive Aufspannung 7, die speziell an diesen einen Turbinenschaufeltyp angepasst ist, in einer Maschine 4 eingespannt, um das Bauteil 120, 130 zu halten, um es mittels eines Werkzeuges 13 (Fräser, Schleifer o.ä.) zu bearbeiten. Dabei müssen für die von verschiedenen Gasturbinentypen verschiedenen Turbinenschaufeln 120, 130 verschiedene Aufspannungen 7 verwendet werden, was zu einer Vielzahl von Aufspannungen 7 führt. Für eine andere Maschine sind wiederum andere Aufspannungen 7 notwendig.

Figur 2 zeigt beispielhaft ein flexibles Aufnahmesystem 19. Das flexible Aufnahmesystem 19 weist einen mit einem Fluid 16 gefüllten Beutel 10 auf.
Das Beutelmaterial kann beliebig sein, z.B. ein Kunststoffbeutel.
Das Fluid 16 ist vorzugsweise eine Flüssigkeit, kann vorzugsweise auch ein Gel oder ein Schlicker sein.
Das Fluid 16 ist hinreichend viskos, damit es sich an ein Bauteil 120, 130 anschmiegen kann.

Bei einem Schlicker aus Pulver, Binder, Lösungsmittel wird das Fluid fest, wenn das Lösungsmittel verdampft.
Ebenso kann ein Schlicker aus Pulver und Flüssigkeit gefroren werden.

In Figur 3 ist ein Bauteil 120, 130 gezeigt, das ein flexibles Aufnahmesystem 19 aufweist, das eine einzuspannende Fläche 406 eines Bauteils 120, 130 umhüllt.

Die Turbinenschaufel 120, 130 mit dem flexiblen Aufnahmesystem 19 wird in die Maschine 4 eingespannt und bezüglich des Werkzeugs 13 ausgerichtet. Die zu bearbeitende Fläche stellt bspw. der Schaufelfuß 400, so dass der Beutel 10 das Schaufelblatt 406 umhüllt. Das Fluid wird verfestigt, insbesondere zum Erstarren gebracht und bildet eine feste Aufnahme 19'. Das kann bei Wasser in Form von Vereisen (-ΔT) erfolgen oder bei magnetorheologischen Flüssigkeiten durch Anlegen eines Magnetfelds (+B). Das Bauteil 120, 130 wird dann bearbeitet.

Wird das flexible Aufnahmesystem 19 nicht mehr benötigt, so kann das Magnetfeld abgeschaltet oder die Temperatur wieder erhöht werden, so dass die Flüssigkeit in dem Beutel 10 wieder sehr niedrig viskos wird, das Bauteil 120, 130 herausgenommen werden und das Aufnahmesystem nochmals verwendet werden kann.

Die Vorrichtung 1 kann auch so ausgestaltet sein, dass das Fluid 16 ohne Beutel 10 als flexibles Aufnahmesystem verwendet werden kann.

In Figur 4 wird mit einer Referenzschaufel 101 eine feste Aufnahme 19' in der Maschine bereitgestellt (Ablauf gemäß Figur 3).

Die Referenzschaufel 101 wird vorzugsweise nicht bearbeitet sondern nach Erstarren des Fluids 16 herausgenommen.

Dieses Aufnahmesystem 19' kann nun für jede Turbinenschaufel 120, 130 des gleichen Typs wie die Referenzschaufel verwendet werden.

Dazu wird eine zu bearbeitende Turbinenschaufel 11 in die fest Aufnahme 19' eingebracht und bearbeitet. Dieser Schritt kann für mehrere Turbinenschaufeln wiederholt werden.

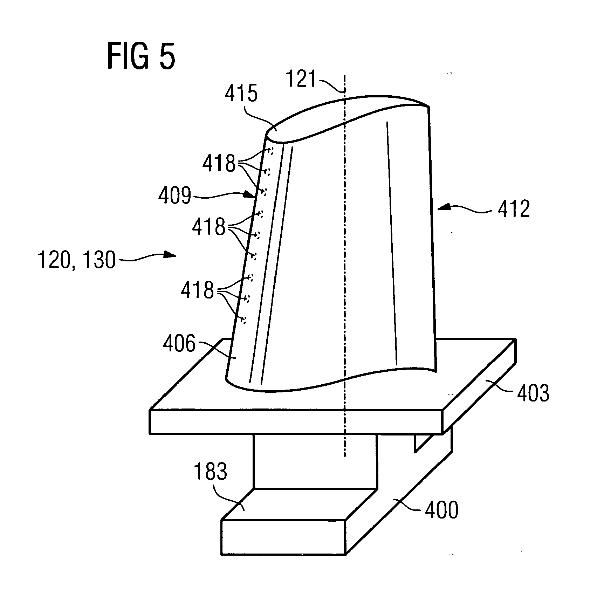

Die Figur 5 zeigt beispielhaft eine Gasturbine 100 in einem Längsteilschnitt.
Die Gasturbine 100 weist im Inneren einen um eine Rotationsachse 102 drehgelagerten Rotor 103 mit einer Welle 101 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.
Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.
Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.
Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).
Als Material für die Bauteile, insbesondere für die Turbinenschaufel 120, 130 und Bauteile der Brennkammer 110 werden beispielsweise eisen-, nickel oder kobaltbasierte Superlegierungen verwendet.
Solche Superlegierungen sind beispielsweise aus der EP 1 204 776 B1, EP 1 306 454, EP 1 319 729 A1, WO 99/67435 oder WO 00/44949 bekannt.

Ebenso können die Schaufeln 120, 130 Beschichtungen gegen Korrosion (MCrAlX; M ist zumindest ein Element der Gruppe Eisen (Fe), Kobalt (Co), Nickel (Ni), X ist ein Aktivelement und steht für Yttrium (Y) und/oder Silizium, Scandium (Sc) und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1.

Auf der MCrAlX kann noch eine Wärmedämmschicht vorhanden sein, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

Die Figur 4 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.
Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).

Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.
Die Dichte liegt vorzugsweise bei 95% der theoretischen Dichte.
Auf der MCrAlX-Schicht (als Zwischenschicht oder als äußerste Schicht) bildet sich eine schützende Aluminiumoxidschicht (TGO = thermal grown oxide layer).

Vorzugsweise weist die Schichtzusammensetzung Co-30Ni-28Cr-8A1-0,6Y-0,7Si oder Co-28Ni-24Cr-10A1-0,6Y auf. Neben diesen kobaltbasierten Schutzbeschichtungen werden auch vorzugsweise nickelbasierte Schutzschichten verwendet wie Ni-10Cr-12Al-0,6Y-3Re oder Ni-12Co-21Cr-11A1-0,4Y-2Re oder Ni-25Co-17Cr-10A1-0,4Y-1,5Re.

Auf der MCrAlX kann noch eine Wärmedämmschicht vorhanden sein, die vorzugsweise die äußerste Schicht ist, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Die Wärmedämmschicht bedeckt die gesamte MCrAlX-Schicht. Durch geeignete Beschichtungsverfahren wie z.B. Elektronenstrahlverdampfen (EB-PVD) werden stängelförmige Körner in der Wärmedämmschicht erzeugt.
Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAlX-Schicht.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

## Patentansprüche

1. Vorrichtung (1) mit flexiblem Aufnahmesystem (19) für die mechanische Bearbeitung von Bauteilen (120, 130), das (19) einen mit einem Fluid (16) gefüllten Beutel (10) aufweist,
der (10) das Bauteil (120, 130) teilweise umhüllen kann und
wobei das Fluid (16) in dem Beutel (10) verfestigt, insbesondere zum Erstarren gebracht werden kann.

2. Flexible Vorrichtung nach Anspruch 1,
bei dem das Fluid Wasser aufweist und durch Vereisen erstarrbar ist.

3. Flexible Vorrichtung nach Anspruch 1,
bei dem das Fluid eine magnetorheologische Flüssigkeit ist und durch ein Magnetfeld erstarrbar ist.

4. Flexible Vorrichtung nach Anspruch 1, 2 oder 3,
bei dem das Fluid eine Flüssigkeit ist.

5. Verfahren zum Bearbeiten eines Bauteils (120, 130),
bei dem vorzugsweise eine flexible Vorrichtung (1) nach Anspruch 1, 2, 3 oder 4 verwendet wird und
wobei in einem ersten Schritt das flexible Aufnahmesystem (19) um ein erstes Bauteil (101, 120, 130) gelegt wird in eine Maschine (4) eingebracht wird,
bei dem dann das Fluid (16) verfestigt, insbesondere erstarren gelassen wird.

6. Verfahren nach Anspruch 5,
wobei ein erstes Bauteil (101) als ein Referenzbauteil verwendet wird und
in einem nächsten Schritt das Referenzbauteil (101) entfernt wird
und dann weitere zu bearbeitende Bauteile (11, 120, 130) des gleichen Typs wie das Referenzbauteil (101) in dem so geformten flexiblen Aufnahmesystem (19) bearbeitet werden.

7. Verfahren nach Anspruch 5,
bei dem das Bauteil (120, 130) nach der Verfestigung des Fluids (16) bearbeitet wird.
